Europäisches Patentamt

(19) European Patent Office

Office européen des brevets

(11) Publication number: **0 246 034**
**A2**

(12) **EUROPEAN PATENT APPLICATION**

(21) Application number: **87304096.8**

(22) Date of filing: **07.05.87**

(51) Int. Cl.⁴: **G 01 R 31/28**

(30) Priority: **16.05.86 US 864199**

(43) Date of publication of application:
**19.11.87 Bulletin 87/47**

(84) Designated Contracting States: **DE ES FR GB**

(71) Applicant: **AMERICAN TELEPHONE AND TELEGRAPH COMPANY**
**550 Madison Avenue**
**New York, NY 10022 (US)**

(72) Inventor: **Savicki, Joseph Peter**
**Apt. 42, Clinton Garden Apts. School Street**
**Clinton New Jersey 08809 (US)**

**Teneketges, Nicholas Arthur**
**511 Ridgedale Avenue**
**East Hanover New Jersey 07936 (US)**

(74) Representative: **Johnston, Kenneth Graham et al**
**Western Electric Company Limited 5 Mornington Road**
**Woodford Green Essex, IG8 OTU (GB)**

The title of the invention has been amended (Guidelines for Examination in the EPO, A-III, 7.3).

(54) Method of testing electronic assemblies while they are being produced.

FIG. 2

㉗ The fabrication procedure for a dense microminiature electronic assembly that includes a substrate (10) containing multiple interconnection nets (e.g, 12, 40, 42, 43, 44, 46, 47 in FIG. 2) typically requires that the nets be tested before components are attached thereto. Testing is accomplished by probing each net only once. The waveform (80 or 86) reflected from the net is then compared to the reflected waveform (76) obtained from a previously measured good net or from design information representative of a good net. The nature and location of any errors (e.g., opens, shorts) in each net are thereby rapidly determined.

**Description**

FABRICATION OF ELECTRONIC ASSEMBLIES

Background of the Invention

This invention relates to electronic assemblies that include substrates on which multiple microminiature interconnections are formed and, more particularly, to a testing method for use in fabricating such assemblies.

In the continuing quest for high-performance electronic assemblies, various approaches are being investigated for achieving a very-high-density interconnection of integrated-circuit chips. In one such known approach, a dense pattern of lithographically defined microminiature conductors are formed on a substrate. In turn, the pattern is utilized to interconnect a number of integrated-circuit chips that are to be mounted on the substrate in electrical contact with portions of the interconnection pattern.

Such a known interconnection substrate may include multiple closely spaced conductors connected in a prescribed pattern to a large number of input/output pads located along the perimeter of the substrate. Additionally, these conductors extend to pads distributed throughout interior portions of the surface of the substrate. In particular, these interior pads are located at specified regions where chips are to be attached to the inteconnection pattern. Bonding pads on the chips are designed to be respectively attached to these interior pads on the interconnection substrate by, for example, standard face-down solder-bonding techniques.

In practice, the aforedescribed substrate interconnection pattern comprising conductors and pads is typically composed of a large number of so-called interconnection nets. (A net comprises a continuous electrical connection among two or more pads.) Each net is designed to be electrically isolated from all other nets.

It is important that the substrate interconnection pattern be thoroughly tested and, if necessary, repaired before chips are actually attached thereto. For each net in the pattern, pad-to-pad continuity must be tested. Thus, each net with more than two pads will typically be probed for continuity more than once. Also, each net must be tested for the possibility of shorts with respect to neighboring nets and respect to power and ground conductors. This involves considerable additional probing of the nets. By means of such extensive testing, the nature and in some cases the approximate location of faults in the interconnection pattern can be thereby determined.

Unfortunately, the aforedescribed testing approach as applied to a dense microminiature interconnection substrate is extremely time-consuming. Such conventional testing can therefore add considerably to the overall cost of an electrical assembly that includes the interconnection substrate. Accordingly, considerable efforts have been directed at trying to devise more effective techniques for testing interconnection substrates. It was recognized that these efforts, if successful, had the potential for contributing importantly to providing improved low-cost electronic assemblies.

Summary of the Invention

Hence, an object of the present invention is a more cost-effective procedure for fabricating electronic assemblies. More specifically, an object of this invention is an improved method for testing interconnection substrates included in such assemblies.

Briefly, these and other objects of the present invention are realized in a specific illustrative embodiment thereof in which a substrate having a multitude of interconnection nets thereon is tested in a relatively high-speed manner. In accordance with applicants' invention, each net is contacted with a test probe only once. A predetermined test waveform is applied to one pad of each net. The waveform reflected from the net back to the probed pad is then compared to the reflected waveform obtained from a previously measured good net or from design information representative of a good net. The nature and location of any errors (e.g., opens, shorts) in each net can be thereby rapidly determined.

More specifically, applicants' invention is a method of fabricating an electronic assembly that comprises an interconnection substrate that includes multiple nets each of which comprises a continuous electrical connection among two or more pads, which nets are to be electrically tested before mounting components on the substrate in electrical contact with selected pads. In particular, applicants' method is characterized by the steps of applying a test signal to only one pad of each net thereby to cause a signal representative of the condition of the net to be reflected back to the pad, and comparing the reflected signal with a standard signal representative of a good counterpart of the net being tested.

Brief Description of the Drawing

A complete understanding of the present invention and of the above and other features thereof may be gained from a consideration of the following detailed description presented hereinbelow in connection with the accompanying drawing, not drawn to scale, in which:

FIG. 1 is a top view of an interconnection substrate of the type to which applicants' inventive principles are illustratively applicable;

FIG. 2 is a schematic depiction of a specific illustrative system designed to test an interconnection substrate in accordance with applicants' inventive principles;

and FIGS. 3 and 4 are representative waveforms useful in explaining the mode of operation of the FIG. 2 system.

Detailed Description

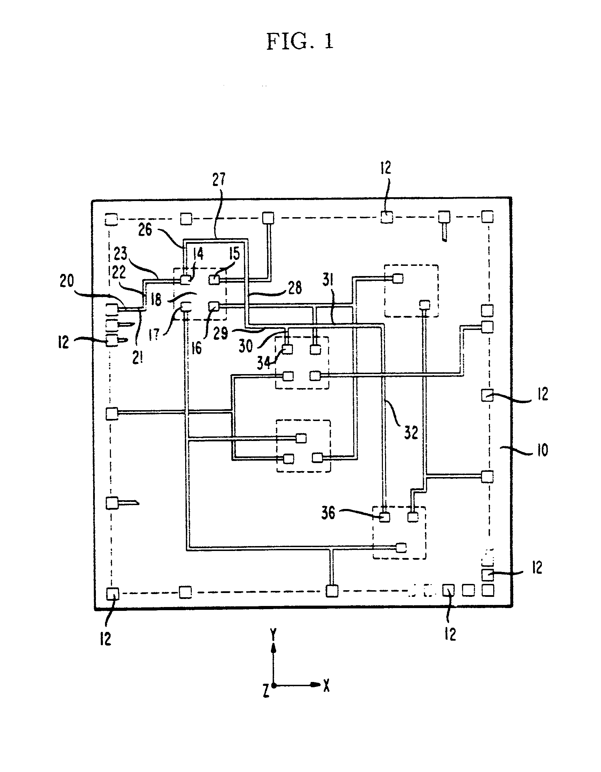

A specific illustrative interconnection substrate is shown in FIG. 1 and will be described in detail below.

The principles of the present invention are particularly applicable to the fabrication of this type of substrate. But it will be apparent that applicants' inventive principles are also applicable to a variety of other interconnection substrates of the type included in electronic assemblies.

The specific interconnection substrate shown in FIG. 1 comprises a wafer 10 made, for example, of silicon having a thickness in the z direction of approximately 500 micrometers (μm). Illustratively, the wafer 10 is square, measuring about 10 centimeters (cm) on a side.

In standard ways known in the art, multi-level metallization patterns, including lithographically defined X- and Y-signal conductors, are formed on the wafer 10 of FIG. 1. So as not to unduly clutter the drawings, only a few of these conductors are explicitly shown in FIG. 1.

In the particular illustrative embodiment represented in FIG. 1, multiple conductive bonding pads 12 are disposed around the periphery of the wafer 10. Additionally, sets of conductive bonding pads such as the set designated 14 through 17 are distributed throughout interior portions of the depicted interconnection substrate. Only a few of these interior and peripheral pads are explicitly shown in FIG. 1. Each set of interior pads is designed to be contacted by respective mating pads on a subsequently attached integrated-circuit chip. Dash lines, such as the dash line 18 around the pads 14 through 17, represent the outlines of such subsequently attached chips. Attachment can be done, for example, by conventional face-down solder-ball bonding techniques.

An interconnection substrate of the type represented in FIG. 1 also typically includes ground and power conductors (not shown) which may, for example, comprise planar members, as is well known. By way of example, these planar conductors, as well as the aforementioned X- and Y-signal conductors and bonding pads, are typically made of a suitable metal such as aluminum or copper. Conventional interlevel dielectrics are utilized to electrically isolate the conductors.

As indicated in FIG. 1, a signal conductor 20 comprising X-direction segments 21 and 23 and Y-direction segment 22 extends between peripheral bonding pad 12 and interior bonding pad 14. Illustratively, the conductor 20 and each of the other depicted conductors is approximately 10-to-20 μm wide and about 2 μm thick in the Z direction. These signal conductors may in practice be placed as close as 10 μm to each other. Each of the pads 12 and 14 as well as each of the other pads on the depicted substrate measures, for example, approximately 100 μm by 100μm and is about 2 μm thick. In this particular embodiment, the center-to-center spacing of the peripheral pads 12 is about 200 μm.

Thus, in an interconnection substrate of the particular illustrative type represented in FIG. 1 and specified above, as many as several thousand bonding pads 12 may be distributed around the periphery of the wafer 10. In turn, each of these pads is electrically connected to a signal conductor or to one of the aforementioned power and ground conductors. Similarly, the bonding pads at each chip site denoted in FIG. 1 are also connected to these conductors. In a practical embodiment, as many as approximately 100 chip sites may be included in the particular interconnection substrate design represented in FIG. 1.

As mentioned earlier above, a pattern of conductors and pads such as represented in FIG. 1 may be regarded as comprising multiple so-called interconnection nets. Each net comprises a continuous electrical interconnection among two or more pads. Thus, for example, a portion of one particular illustrative such interconnection net includes the previously specified upper left-hand peripheral pad 12, the signal conductor segments 21 through 23 and the interior pad 14. Further, this net includes signal conductor segments 26 through 32 and interior pads 34 and 36.

Testing of the multiple interconnection nets depicted in FIG. 1 is typically carried out before attaching chips to the wafer 10. In view of the small size and large number of interconnection nets, it is apparent that systematic testing of such a dense interconnection pattern for faults such as opens and shorts is a formidable task.

Various straightforward approaches for testing the interconnection substrate of FIG. 1 are available. For example, the continuity of signal conductors in an interconnection net may be determined by successively measuring the direct-current conductivity of conductor segments between pads. This is done by successively probing pairs of pads included in each net.

Thus, for the particular illustrative net specified earlier above, the conductor segment that extends between the upper left-hand peripheral pad 12 and the interior pad 14 can be tested by respectively contacting these pads with test probes. Once that segment has been determined to be electrically continuous or not, the probe contacting the peripheral pad 12 can be moved to the interior pad 34. The conductor segments 26 through 30 are thereby checked. Subsequently, the probe contacting the pad 14 can be moved to the interior pad 36 thereby checking the conductor segments 30 through 32 for continuity.

By means of the three aforespecified separate probings, the particular illustrative net specified above can be tested for the existence of opens therein. Every other net that includes more than a direct connection between two pads must also be probed more than once to perform a continuity test thereon.

Additionally, every net in the interconnection substrate shown in FIG. 1 must also be checked for shorts. Such shorts can exist between the net under test and any other nearby net or between the net under test and the power or ground conductor.

Testing for shorts typically includes placing one test probe in contact with a pad of the net to be tested and placing another test probe successively in contact with pads respectively included in nearby nets and with power and ground conductors. During this probing, any indication of direct-current resistance below some prescribed minimum value will indicate a short.

It is apparent that the aforedescribed straightforward testing approach involves multiple probings of each net an interconnection substrate. This approach is therefore extremely time-consuming and expensive. Also, the likelihood of deleteriously scratching the pads or conductors of each net is a direct function of the number of times that a net must be probed.

In accordance with the principles of the present invention, an interconnection substrate such as the one depicted in FIG. 1 is tested in a relatively high-speed manner. Significantly, such testing is carried out by probing each interconnection net only once. By means of this approach, the occurrence of faults such as opens, shorts and other irregularities in each net are rapidly determined. In many cases, the actual location of a fault can also thereby be ascertained.

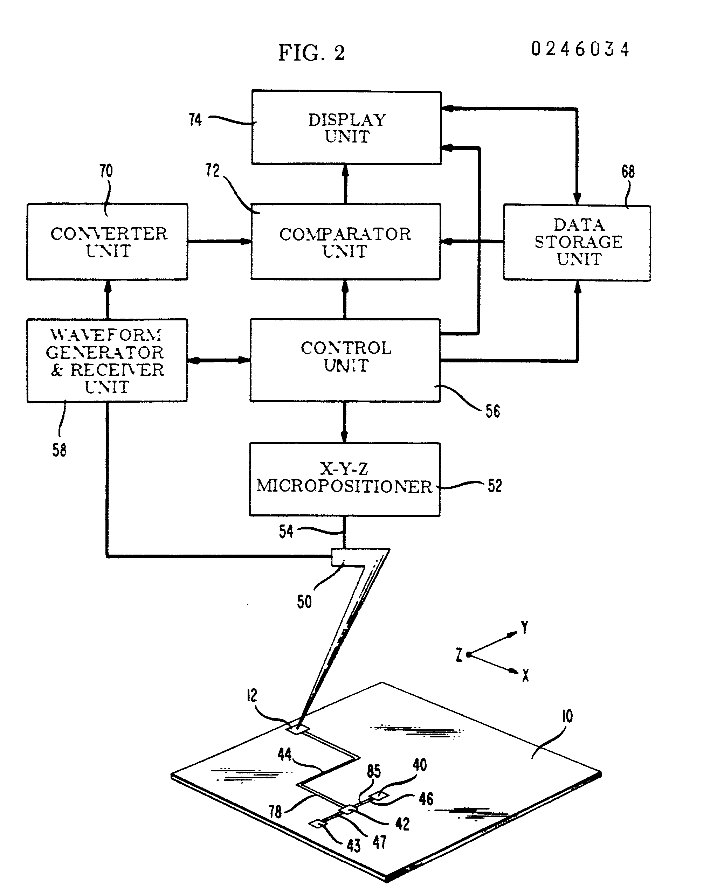

FIG. 2 is a schematic representation of a specific illustrative system adapted to implement applicants' inventive testing method. In FIG. 2, the interconnection substrate to be tested comprises a wafer 10 of the type described above and shown in FIG. 1. So as not to unduly clutter the figure, only one net of a multitude of nets included on the wafer 10 is actually indicated in FIG. 2. The indicated net comprises pads 12, 40, 42 and 43 and signal conductors 44, 46 and 47.

In accordance with applicant's invention, a sharp-pointed probe is utilized to contact one pad of each net to be tested. In FIG. 2, a conductive probe 50 having, for example, a tip whose diameter is approximately 10 μm is shown in contact with the pad 12 of the aforespecified net included on the wafer 10.

Movement of the probe 50 of FIG. 2 to successively contact pads of respective nets to be tested is controlled by a standard X-Y-Z micropositioner 52 which is mechanically coupled by link 54 to the probe 50. In turn, the operation of the micropositioner is determined by electrical signals applied thereto from a control unit 56. In one practical embodiment, the unit 56 comprises a computer that is pre-programmed to cause the micropositioner 52 to move the probe 50 into successive contact with pads of respective nets. In practice, the time period during which the probe 50 is controlled to remain in contact with each such pad is, for example, only about 20 milliseconds. The time required for the probe 50 to move from a position in contact with one pad to a position in contact with the next successive pad of another net is in practice only about 60-to-80 milliseconds. Thus, even for a dense microminiature interconnection substrate including as many as 2000 nets, a total of only about 200 seconds is required to successively probe all the nets.

Electrical signals are applied to the probe 50 (FIG. 2) from a standard waveform generator and receiver unit 58. Although only one lead is explicitly shown between the unit 58 and the probe 50, it is to be understood that in practice another lead typically extends between the unit 58 and a point of reference potential in the interconnection substrate. That point can, for example, be a point on the aforementioned ground conductor included in the interconnection substrate.

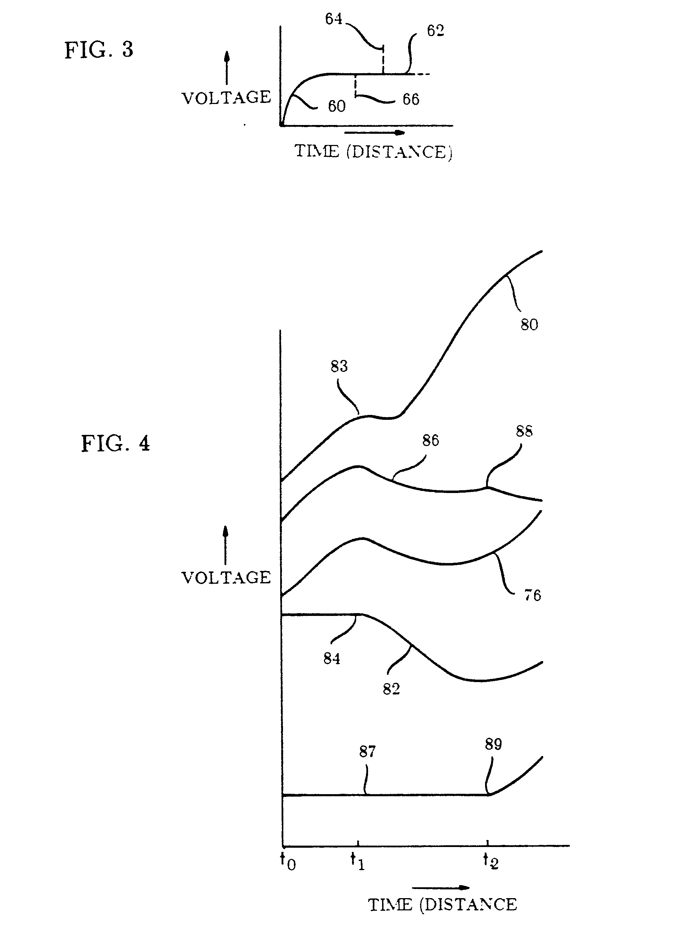

Ideally, the unit 58 of FIG. 2 is designed to apply to a pad via the probe 50 a rapid-rise-time voltage waveform 60 of the type depicted in FIG. 3. But, because of loading and other effects, the waveform actually applied to the pad of a net to be tested typically deviates considerably from an ideal step-type waveform. The actual waveform so applied will be specified later below in connection with a description of FIG. 4.

The unit 58 shown in FIG. 2 may comprise, for example, a conventional time domain reflectometer. A typical such reflectometer is commercially available from Hewlett-Packard Co., 120 West Century Road, Paramus, New Jersey (Model 7104 oscilloscope with TDR plug-in) or from Tektronix Co., 40 Gill Lane, Woodbridge, New Jersey (Model 8510 network analyzer with TDR option).

Heretofore, time domain reflectometers have been used to test individual submarine cables or land lines of the type employed in long-distance transmission systems. But, to applicants' knowledge, time domain reflectometers have not heretofore been utilized or suggested for utilization in connection with testing a dense microminiature interconnection substrate of the type described herein. For such substrates, other testing techniques such as the one specified earlier above, albeit time consuming, are available. Only applicants conceived that time domain reflectometry might be applicable to and achieve significant advantages when employed to test microminiature electronic assemblies that include multiple interconnection nets. Such a meritorious conception constituted an unobvious extension of a known technique to assemblies of a type never before contemplated as being amenable to this sort of testing approach. Applicants' unobvious approach as applied to microminiature electronic assemblies comprises a significant and unique solution to a vexing problem that had heretofore not been resolved in a satisfactory way by workers skilled in the art.

The application of a step waveform to an idealized fault-free conductor provides a reflected wave of the type represented by solid curve 62 in FIG. 3. If an open or break is present at some point along the conductor, a positive-going spike will occur in the reflected waveform. Such a spike is indicated in FIG. 3 by dash line 64. The time of occurrence of the spike 64 as represented on the abscissa of FIG. 3 is directly related to the distance between the open in the conductor under test and the point of application of the step waveform. Thus, the abscissa of FIG. 3 can also be considered to be a direct indicator of distance along the conductor being tested.

If a short is present at some point along the conductor under test, a negative-going spike will occur in the idealized reflected waveform of FIG. 3. Such a spike is represented by dash line 66. As before, the time of occurrence of the spike 66 is a direct indicator of the distance between the fault in the conductor and the point of application of the step waveform.

In an actual interconnection substrate of the type described herein, each net typically includes branches, pads and other discontinuities that cause the reflected waveform to be a relatively complex variant of the idealized curve shown in FIG. 3. Moreover, many if not all of the multitude of nets on such a substrate are respectively different in configuration. Thus, each different net responds to the application thereto of an input step signal by providing a relatively complex and unique reflected waveform.

In accordance with the principles of applicants' invention, the waveform reflected from each probe interconnection net under test is compared with the waveform representative of a fault-free such net. This latter or standard waveform is obtained either from an actual good version of each net or derived from design information definite of each net. Illustratively, the standard waveforms are stored in sequence in the form of digital data representations in a unit 68 (FIG. 2) in the respective order in which the nets of an interconnection substrate are to be probed.

Additionally, the waveform reflected from each net under test is applied by the generator and receiver unit 58 of FIG. 2 to a standard converter unit 70. In the unit 70, each waveform is converted to a digital data representation, in conventional ways known in the art. Then in a standard unit 72, successive digital representations respectively indicative of successive points of a reflected waveform are compared, under control of the unit 56, point by point with corresponding digital representations stored in the data storage unit 68. These latter representations are respectively indicative of the same points on a standard waveform associated with a good counterpart of the actual net under test.

The point-by-point comparison operation carried out by the unit 72 shown in FIG. 2 is effective to provide an indication of any variation between a particular point of a reflected waveform derived from a net under test and the corresponding respective point of the associated standard waveform. Moreover, the unit 72 provides an indication of whether a detected variation or difference in digital representations of the two compared points is positive or negative. In turn, this indication in effect signifies whether the variation stems from a positive-going or negative-going excursion of the reflected waveform derived from the net under test. Thus, the sign of any detected variation provides an indication of the nature (open or short) of the detected fault. Further, the time of occurrence of the two-point comparison that provides a fault signal is a direct indicator of the location of the fault in the net under test.

Illustratively, the output of the comparator unit 72 of FIG. 2 is connected to a standard display unit 74. To facilitate fault location and repair, the unit 74 is arranged, for example, to display information such as which net is being tested and the nature and approximate location of any detected fault.

Fault information displayed on the unit 74 can also if desired be stored in the unit 68. Thus, after a complete testing cycle has been carried out on an interconnection substrate, the unit 68 will have stored therein complete information indicative of which, if any, of the multiple tested nets are faulty.

Depending on factors such as how many nets are faulty and the nature and location of the faults, a decision can then be made as to whether the substrate requires and warrants repair.

Subsequently, chips (and/or other electronic components) are mounted on substrates that were determined by testing to be good or that after testing were repaired to be good. Various techniques such as face-down solder-ball bonding are available for mounting and electrically connecting such components to the interconnection nets on a substrate.

FIG. 4 is a specific illustrative depiction of various waveforms actually observed during a testing cycle carried out in accordance with the principles of the present invention. By way of example, curve 76 in FIG. 4 is representative of the standard waveform that is applied to and reflected from a good version of the particular interconnection net shown in FIG. 2. In accordance with the specific illustrative testing procedure described above, a digital data representation of the standard waveform 76 is stored in the unit 68 of FIG. 2.

Assume now that a single fault is present in the specific interconnection net shown in FIG. 2. In particular, assume that an open or break is present at point 78 of the signal conductor 44. The waveform derived from tesing such a faulty net is designated by reference numeral 80 in FIG. 4. As described earlier above, this waveform 80 is applied by the unit 58 of FIG. 2 to the converter unit 70 wherein a digital data representation of the waveform 80 is generated.

A comparison of the aforementioned data representations of the waveforms 76 and 80 of FIG. 4 is carried out in the unit 72 (FIG. 2). A graphical indication of the difference between these waveforms is represented by waveform 82 of FIG. 4.

In the interval between $t_0$ and $t_1$ in FIG. 4, the waveforms 76 and 80 are substantially identical. Hence the difference waveform 82 includes a flat or zero-difference portion in this time interval. At point 83 on the waveform 80, the waveform 80 begins to deviate in a positive-going direction from the standard waveform 76. Thus, at a corresponding point 84 on the difference waveform 82, the waveform 82 begins in effect to indicate the existence of a difference between a good net and the faulty net under test. The first occurrence of this non-flat difference signal at the point 84 corresponds approximately to a time immediately subsequent to $t_1$. In turn, as discussed earlier above, the first occurrence also directly indicates the distance of the fault (open) from the pad 12 to which the test signal was initially applied.

For purposes of another specific illustrative example, assume now that a single different type of fault is present in the specific interconnection net shown in FIG. 2. In particular, assume that a short to another net or to the power or ground conductor is present at point 85 of the signal conductor 46. The waveform derived from testing such a faulty net is designated by reference numeral 86 in FIG. 4. As described above, this waveform 86 is applied by the unit 58 of FIG. 2 to the converter unit 70 wherein a digital data representation of the waveform 86 is generated.

A comparison of the aforementioned data representations of the waveforms 76 and 86 of FIG. 4 is carried out in the unit 72 (FIG. 2). A graphical indication of the difference between these waveforms is represented by waveform 87 of FIG. 4.

In the interval between $t_0$ and $t_2$ in FIG. 4, the waveforms 76 and 86 are substantially identical. Hence the difference waveform 87 includes a flat or zero-difference portion in this time interval. At point 88 on the waveform 86, the waveform 86 begins to deviate in a negative-going direction from the standard waveform 76. Thus, at a corresponding point 89 on the difference waveform 87, the waveform 87 begins in effect to indicate the existence of a difference between a good net and the faulty net under test. The first occurrence of this non-flat difference signal at the point 89 corresponds approximately to a time immediately subsequent to $t_2$. In turn, this first occurrence also directly indicates the distance of the fault (short) from the pad 12 to which the test signal was initially applied.

Finally, it is to be understood that the above-described techniques and arrangements are only illustrative of the principles of the present invention. In accordance with these principles, numerous modifications and alternatives may be devised by those skilled in the art departing from the spirit and scope of the invention.

**Claims**

1. A method of fabricating an electronic assembly that comprises an interconnection substrate (10) that includes multiple nets (e.g., 12, 40, 42, 43, 44, 46, 47) each of which comprises a continuous electrical connection among two or more pads (12, 40, 42, 43), which nets are to be electrically tested before mounting components on said substrate in electrical contact with selected pads, said method being characterized by the steps of applying a test signal (76) to only one pad (12) of each net thereby to cause a signal (76, 80 or 86) representative of the condition of said net to be reflected back to said pad, and comparing said reflected signal (76, 80 or 86) with a standard signal (76) representative of a good counterpart of the net being tested.

2. A method as in claim 1 wherein test signals are applied to said nets via a probe (50), said method comprising the further step of moving said probe (50) in accordance with a programmed sequence to successively contact selected pads of the respective nets to be tested.

3. A method as in claim 2 comprising the further step of storing a complete set of standard signals respectively representative of good counterparts of the nets to be tested, applying said stored standard signals to a comparator unit (72) in respective unison with said programmed sequence, and simultaneously applying to said comparator unit (72) the successive reflected signals derived from contacting pads of the respective nets to be tested.

4. A method as in claim 3 wherein the stored set of signals comprise digital data representations of said standard signals, said method comprising the further step of converting said reflected signals to digital data representations thereof before applying the signals to said comparator unit (72).

5. A method as in claim 4 comprising the further step of displaying the successive outputs of said comparator unit (72) to provide a visual indication of the variance if any that exists between the reflected signals and the respectively corresponding standard signals.

FIG. 1

FIG. 2

0246034

0246034

FIG. 3

FIG. 4